Europäisches Patentamt

European Patent Office

Office européen des brevets

(11) Veröffentlichungsnummer: **0 248 988**
**B1**

## EUROPÄISCHE PATENTSCHRIFT

(45) Veröffentlichungstag der Patentschrift:
31.10.90

(51) Int. Cl.⁵: **H01L 21/82, H01L 27/08**

(21) Anmeldenummer: 87104506.8

(22) Anmeldetag: 26.03.87

(54) Verfahren zum Herstellen von hochintegrierten komplementären MOS-Feldeffekttransistorschaltungen.

(30) Priorität: 10.06.86 DE 3619506

(43) Veröffentlichungstag der Anmeldung:
16.12.87 Patentblatt 87/51

(45) Bekanntmachung des Hinweises auf die Patenterteilung:
31.10.90 Patentblatt 90/44

(84) Benannte Vertragsstaaten:
AT DE FR GB IT NL SE

(56) Entgegenhaltungen:
EP-A- 0 085 168
EP-A- 0 123 182
EP-A- 0 135 163
EP-A- 0 163 871

PATENT ABSTRACTS OF JAPAN, Band 9,
Nr. 251 (E-348)[1974], 8. Oktober 1985; &
JP-A-60 101 963

(73) Patentinhaber: Siemens Aktiengesellschaft,
Wittelsbacherplatz 2, D-8000 München 2(DE)

(72) Erfinder: Neppl, Franz, Dr., St. Quirin-Platz 6,
D-8000 München 90(DE)
Erfinder: Jacobs, Erwin, Dr., Millöckerstrasse 76,
D-8011 Vaterstetten(DE)
Erfinder: Winnerl, Josef, Dr., Schubertstrasse 2,
D-8300 Landshut(DE)
Erfinder: Mazurè-Espejo, Carlos-Alberto, Dr.,
Heinrich-Egger-Strasse 10, D-8011 Kirchseeon(DE)

ACTORUM AG

**Beschreibung**

Die Erfindung betrifft ein Verfahren zum Herstellen von hochintegrierten, komplementären MOS-Feldeffekttransistorschaltungen (CMOS-Schaltungen), bei dem für die Aufnahme der n- bzw. p-Kanal-Transistoren der Schaltung im Halbleitersubstrat p- bzw. n-dotierte Wannen erzeugt werden, in welche zur Einstellung der verschiedenen Transistoreinsatzspannungen die entsprechenden Dotierstoffe durch Ionenimplantationen eingebracht werden, bei dem als Halbleitersubstrat n+- bzw. p+-dotiertes Silizium mit einer darauf befindlichen n−- bzw. p−-dotierten epitaxialen Schicht verwendet wird und bei dem die Herstellung der Source/Drain-und Gatebereiche sowie die Erzeugung des Zwischen- und Isolationsoxids und der Leiterbahnebene nach bekannten Verfahrensschritten der MOS-Technologie vorgenommen wird.

Ein solches Verfahren ist beispielsweise aus der europäischen Patentanmeldung 0 135 163 zu entnehmen.

Die Aufgabe, die der vorliegenden Erfindung zugrundeliegt, besteht in der Erhöhung der Latch-up-Festigkeit von CMOS-Schaltungen bei gleichbleibend guten Transistoreigenschaften sowie in der Durchführung eines CMOS-Prozesses, bei dem diese Eigenschaften einer integrierten Schaltung ohne großen technischen Aufwand erhalten werden.

Moderne CMOS-Prozesse verwenden Technologien, bei denen sowohl n- als auch p-Kanaltransistoren in Wannen liegen.

Die Einstellung der verschiedenen Transis tor-Einsatzspannungen (Dünnoxidtransistoren und Feldoxidtransistoren beider Typen) erfolgt durch mehrfache, aufeinander abgestimmte Ionenimplantationen.

Eine erhöhte Latch-up-Festigkeit (= Unterdrückung der parasitären Bipolareffekte) wurde bisher entweder durch Verwendung einer epitaxialen Schicht auf einem niederohmigen Substrat oder durch die Verwendung eines "retrograde well" erhalten.

Die Verwendung einer epitaxialen Schicht in einem CMOS-Prozeß ist aus einem Aufsatz von L. C. Parillo et. al. aus dem Technical Digest IEDM 1980, 29.1, Seiten 752 bis 755, bekannt. Die beiden n- bzw. p-dotierten Wannen werden in einem CMOS-Prozeß mittels selbstjustierender Prozeßschritte unter Verwendung einer Maske hergestellt. Die selbstjustierende Implantation der beiden Wannen führt bei der üblichen Eindringtiefe von 5 μm (p- und n-Wanne) an der Implantationskante zu einer starken räumlichen Überlappung und ladungsmäßigen Kompensation der n- bzw. p-implantierten Gebiete. Eine negative Folge davon ist, daß die Einsatzspannung des Feldoxidtransistors reduziert wird und die Stromverstärkung der parasitären npn- und pnp-Bipolartransistoren erhöht wird, was zu einer vergrößerten Latch-up-Anfälligkeit führt.

Ein weiteres Verfahren, welches eine epitaxiale Schicht zur Erhöhung der Latch-up-Festigkeit verwendet, ist aus der europäischen Patentanmeldung 0 135 163 zu entnehmen. Bei diesem Verfahren wird die Einsatzspannung der n- und p-Kanal-CMOS-FETs durch spezielle Gatematerialien und angepaßte Gateoxiddicken, sowie eine spezielle Kanalimplantation eingestellt.

Beide Verfahren haben den Nachteil, daß der Schichtwiderstand der p-Wanne im Bereich von einigen kOhm pro square liegt, was die Latch-up-Anfälligkeit zwar vermindert, jedoch nicht ausschließt. Außerdem ist die Empfindlichkeit des Wannen-MOS-FET bezüglich der Substratströme relativ hoch.

Die Verwendung einer "retrograde-well" in einem CMOS-Prozeß ist aus einem Aufsatz von R.D. Rung et al. aus IEEE Transactions on Electron Devices, Vol. ED-28, Nr. 10, Oktober 1981, Seiten 1115 bis 1119, bekannt. Bei diesem Verfahren wird durch Verwendung einer tiefen Implantation mit einem darauf folgenden kurzen Temperschritt ein p- bzw. n-Wannenprofil mit einer erhöhten Dotierung in der Tiefe erzeugt, wodurch bei gleichbleibendem Schichtwiderstand eine flachere Wanne entsteht und der n+/p+-Abstand auf ein Drittel seines Wertes reduziert wird. Ein Nachteil dieses Verfahrens liegt im technischen Zusatzaufwand für die Hochenergie-Implantation.

Aus Patent Abstracts of Japan, Band 9, No 251, (E-348) (1974), 80/10/85 & JP-A 60 101 963 ist ein Herstellverfahren für einen C-MOSFET bekannt, bei dem eine p-dotierte Wanne dadurch erzeugt wird, daß in ein Substrat p-dotierende Ionen implantiert werden. Auf das Substrat wird dann eine n-dotierte Epitaxieschicht aufgewachsen. In die n-dotierte Epitaxieschicht werden wiederum p-dotierende Ionen implantiert. Durch Aufdiffusion der p-dotierenden Ionen aus dem Substrat und durch Abwärtsdiffusion der p-dotierenden Ionen aus der Epitaxieschicht wird die p-Wanne erzeugt.

Aus Patent Abstracts of Japan, Band 9, No 251, (E-348) (1974), 08/10/785 & JP-A 60 101 964 ist ein Herstellverfahren für einen C-MOSFET bekannt, bei dem eine p-Wanne durch Ausdiffusion einer im Substrat vergrabenen p-dotierten Schicht in eine darüberliegende Epitaxieschicht erzeugt wird.

Die Erfindung löst das Problem der Unterdrückung der parasitären Bipolareffekte und damit der Erhöhung der Latch-up-Festigkeit bei einem Verfahren der eingangs genannten Art dadurch, daß

a) auf die n−-, bzw. p−-dotierte erste Epitaxieschicht eine zweite epitaxiale Schicht, die von demselben Leitfähigkeitstyp wie die erste Epitaxieschicht ist, aufgebracht wird,

b) in den oberen Bereich der tieferen, ersten Epitaxieschicht vor dem Aufbringen der zweiten, darüberliegenden (oberen) epitaxialen Schicht in den späteren Wannenbereichen vergrabene Zonen (sogenannte buried layers) mit vergleichsweise hoher Dosis implantiert werden und

c) die Wannen durch Ausdiffusion dieser hochdotierten vergrabenen Zonen in die zweite (obere) epitaxiale Schicht erzeugt werden.

Es liegt im Rahmen der Erfindung, die Wannen zusätzlich durch Diffusion von in die zweite epitaxiale Schicht implantierten Ionen zu erzeugen.

Weitere Ausgestaltungen der Erfindung, insbesondere zwei sehr vorteilhafte Prozeßfolgen, ergeben sich aus den Unteransprüchen.

Da die Wanne durch Ausdiffusion der hochdotierten "buried layers" in die obere epitaxiale Schicht und gegebenenfalls durch Diffusion einer in die obere epitaxiale Schicht implantierten Wannendotierung, die vergleichsweise zu dem hochdotierten buried-layer schwach sein kann, hergestellt wird, kann bei vorgegebener Wannentiefe das für die Wannenerzeugung benötigte Diffusionskonstante-Zeit-Produkt stark reduziert werden. Außerdem kann darüber hinaus die Wannen- und Epitaxieschicht-Dotierung an der Oberfläche und in der Tiefe unabhängig voneinander eingestellt werden, so daß diese Dotierungen optimal an die Transistor- und Latch-up-Festigkeitsanforderungen angepaßt werden können.

Durch das Verfahren nach der Lehre der Erfindung ergeben sich aufgrund der erniedrigten Diffusionskonstante-Zeit-Produkte folgende Vorteile:

a) weniger Kristallfehler,
b) geringere Dotierstoff-Ausdiffusion aus dem hochdotierten Substrat,
c) kein Sonderequipment für Hochtemperaturtemperung größer 1000°C, wie sonst für Wannen-drive-in nötig,
d) kürzere, gemeinsame drive-in-Zeit für beide Wannen,
e) geringere laterale Diffusion und Kompensation der oberflächennahen Bereiche trotz selbstjustierter Wannen,
f) Verringerung des Abstandes Wanne/Epischichtkante wegen des steileren Wannenprofils.

Darüber hinaus ermöglicht die Verwendung der "buried layer":

a) niedrigen Wannenwiderstand und damit verbesserte Latch-up-Festigkeit ohne MOS-FET-Verschlechterung,
b) flache Wanne bei gleichbleibender parasitärer Kollektor-Emitter-Durchbruchsspannung $U_{CEO}$,
c) keine Beweglichkeitsreduktion durch hohe Dotierungen im Kanalbereich,
d) keine aufwendige und kostenintensive Hochenergieimplantation und
e) weniger Wannenkontakte.

3. Aufgrund der erniedrigten lateralen Diffusion bzw. des steileren Wannenprofils wird ein geringerer $n^+/p^+$-Abstand ermöglicht. Zusammen mit der geringeren Zahl benötigter Wannenkontakte ergibt sich dadurch eine höhere Packungsdichte mit verbesserter Latch-up-Festigkeit.

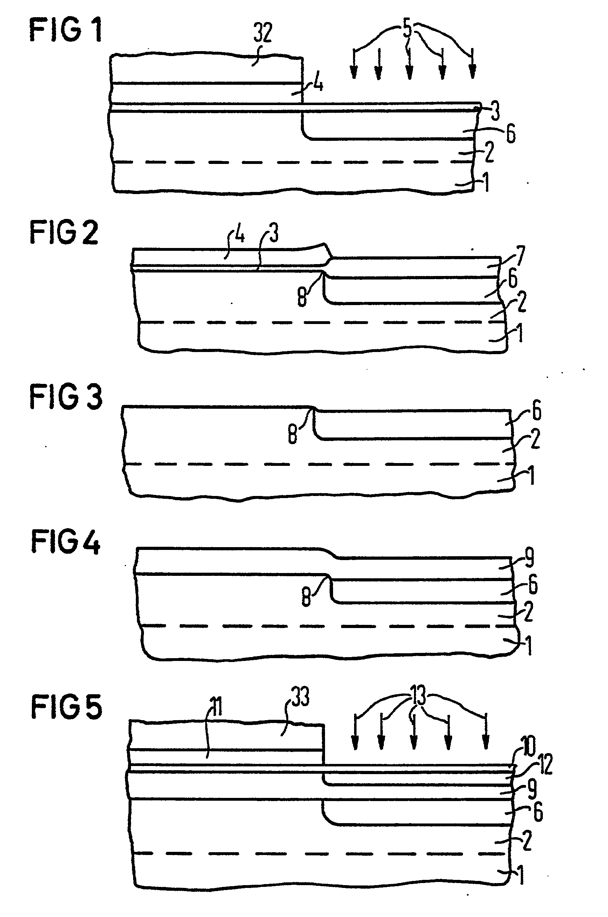

Im folgenden werden anhand der Figuren 1 bis 17 zwei Prozeßfolgen zur Herstellung einer CMOS-Schaltung nach der Lehre der Erfindung noch näher beschrieben. Die Prozeßabläufe sind für einen p-Wannen-Prozeß beschrieben, der auf n-dotiertem Siliziumgrundmaterial aufbaut; sinngemäß sind sie aber auch auf einen n-Wannen-Prozeß basierend auf p-Silizium-Grundmaterial übertragbar.

Die Figuren 1 bis 9 zeigen im Schnittbild die durch die einzelnen Verfahrensschritte erzielten Strukturen, wobei der Einfachheit wegen in jeder Figur mehrere Prozeßfolgen zusammengefaßt dargestellt sind.

Die Figuren 10 bis 14 zeigen eine andere Prozeßfolge, bei der die Erzeugung beider Wannen durch Ausdiffusion von buried layers erfolgt.

In allen Figuren gelten für gleiche Teile gleiche Bezugszeichen.

Die Figuren 15 bis 17 zeigen die in den aktiven Bereichen der n- bzw. p-Kanal-Transistoren erreichten Dotierungsprofile, wobei die Figur 15 das Dotierungsprofil im aktiven Bereich der n-Kanal-Transistoren des in den Figuren 1 bis 9 beschriebenen Ausführungsbeispiel zeigt, während sich die Figuren 16 und 17 auf die im aktiven Bereich der n-Kanal- (Figur 16) bzw. p-Kanal-Transistoren (Figur 17) erreichten Dotierungsprofile des Ausführungsbeispiels gemäß der Figuren 10 bis 14 beziehen.

1. Ausführungsbeispiel:

Figur 1: Auf einem, mit einer ersten n-dotierten Epitaxieschicht 2 von 3 µm Schichtdicke und 0,5 Ohm cm Widerstand versehenen $n^+$-dotierten (100)-orientierten Siliziumsubstrat 1 mit einem spezifischen Widerstand von 0,02 Ohm cm wird eine aus $SiO_2$ (50 nm) und Siliziumnitrid (140 nm) bestehende Doppelschicht 3, 4 erzeugt und die Siliziumnitridschicht 4 mit der Photolackmaske 32 so strukturiert, daß der spätere n-Wannenbereich abgedeckt bleibt. Dann wird durch eine Bor-Ionenimplantation 5 mit einer Dosis und Energie von $1 \times 10^{14}$ cm$^{-2}$ und 25 keV in die mit der Photolackschicht 32 und der Siliziumnitridschicht 4 nicht bedeckten Oberflächenbereiche (späterer p-Wannenbereich) eine hochdotierte, vergrabene Zone 6 (sogenannte buried layer) hergestellt. Mit dieser Zone 6 wird im späteren Prozeßverlauf durch Ausdiffusion dann der Anschluß an die p-Wanne hergestellt. Außerdem führt die Zone 6 zur Reduzierung des Wannenwiderstandes (p-Wanne) und zur Erhöhung der Kollektor-Emitter-Durchbruchsspannung $U_{CEO}$.

Figur 2: Im p-Wannenbereich wird nun nach Entfernung der Photolackmaske 32 durch Aufoxidation der Oberfläche eine $SiO_2$-Schicht 7 (200 nm) erzeugt und damit die Strukturkante 8 gebildet.

Figur 3: zeigt die Anordnung nach Entfernung der Siliziumnitridmaske (4) und der Oxidschicht (3, 7).

Figur 4: zeigt die Anordnung nach der Abscheidung der zweiten n$^-$-dotierten Epitaxieschicht 9 in einer Schichtdicke im Bereich von 1 µm und einem spezifischen Widerstand von 20 Ohm cm.

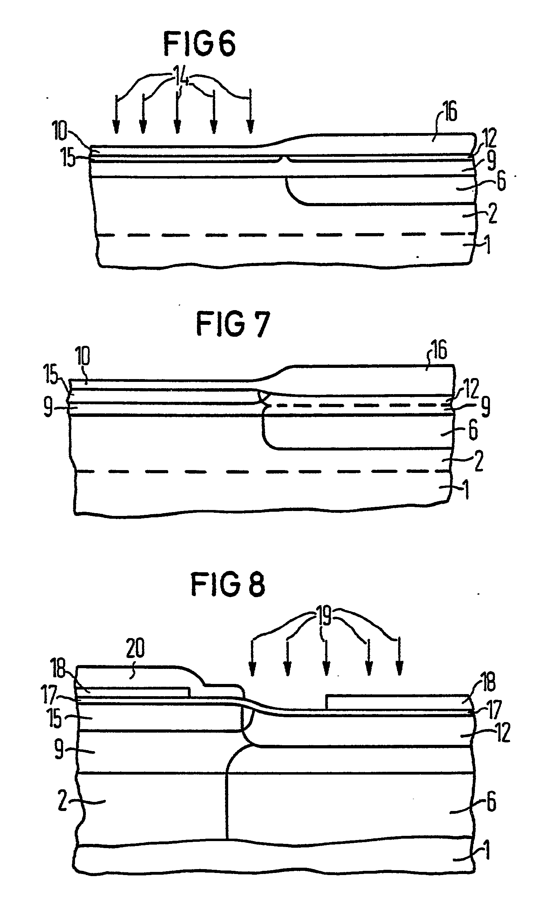

Figur 5: Nach der Herstellung einer weiteren, aus 50 nm $SiO_2$ und 140 nm Siliziumnitrid bestehenden Doppelschicht 10, 11 und Strukturierung der Siliziumnitridschicht 11 mit der Photolackmaske 33 wird die p-Wanne 12 in der n-dotierten Epitaxieschicht 9 durch Bor-Ionenimplantation mit einer Dosis und Energie von $2 \times 10^{12}$ cm$^{-2}$ und 160 keV hergestellt.

Figur 6: Für die nachfolgende Phosphor-Ionenimplantation 14 ($1 \times 10^{12}$ Phosphor cm$^{-2}$ und 180 keV) zur Herstellung der n-Wanne 15 wird über dem p-Wannenbereich 12 vorher durch Aufoxidation eine SiO$_2$-Schicht 16 erzeugt, die Nitridmaske 11 entfernt und ein Temperprozeß durchgeführt.

Figur 7 zeigt die Anordnung nach dem drive-in-Prozeß für die beiden Wannen 12 und 15 bei 1000°C in zwei bis drei Stunden. Nach dem Wannen-drive-in besteht nun eine Verbindung zwischen der p-Wanne 12 und der darunterliegenden p$^+$-buried layer 6.

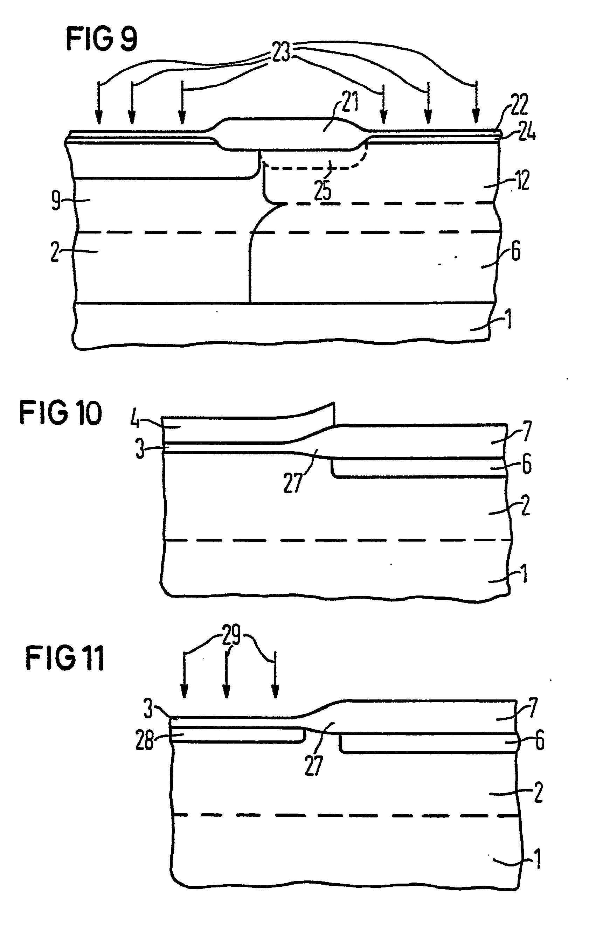

Figur 8: Die gesamte Oxidschicht 10, 16 wird entfernt und erneut eine aus 50 nm SiO$_2$ und 140 nm Siliziumnitrid bestehende Doppelschicht 17, 18 zur Vorbereitung auf den LOCOS-Prozeß (= local oxidation of silicon) erzeugt und strukturiert; die übliche Phototechnik (in der Figur nicht dargestellt) wird durchgeführt. Die Figur zeigt die Anordnung während der Ionenimplantation 19 der Feldoxid-Gebiete der n-Kanal-Transistoren mit Bor-Ionen ($1 \times 10^{13}$ cm$^{-2}$ und 25 bis 90 keV). Dabei ist der n-Wannenbereich (15) mit einer Photolackmaske 20 bedeckt. Es entsteht der in Figur 9 mit 25 bezeichnete p$^+$-dotierte Bereich, der eine ausreichend hohe Einsatzspannung der n-Kanal-Feldoxid-Transistoren gewährleistet.

Figur 9: Nach Entfernung der Photolackmaske 20 und der Erzeugung des Feldoxids 21 durch Oxidation (unter Verwendung der Nitridstrukturen als Oxidationsmaske = LOCOS) wird nach der Entfernung der Nitridmaske 18 in einem Oxidationsprozeß die Oxidschicht 17 (Figur 8) aufoxidiert. Anschließend erfolgt nach Abätzung der Oxidschicht 17 die Erzeugung des Gateoxids 22 in definierter Schichtdicke. Eine ganzflächige Bor-Ionenimplantation 23 mit einer Dosis und Energie von $5 \times 10^{11}$ cm$^{-2}$ und 25 keV erzeugt die Kanaldotierung 24 der p- und n-Kanal-Transistoren und dient zur Einstellung der Einsatzspannungen beider Transistortypen. Ab diesem Prozeßschritt folgt der Prozeß einer konventionellen Technologie, wobei abhängig von Gateoxiddicke und Gatematerial eine oder mehrere Kanalimplantationen durchgeführt werden. Diese Prozesse sind bekannt und beispielsweise auch aus der eingangs genannte europäischen Patentanmeldung 0 135 163 zu entnehmen.

Das im aktiven Bereich der n-Kanal-Transistoren gemäß Figur 9 erreichte Dotierungsprofil ist qualitativ in Figur 15 dargestellt. Dabei ist als Ordinate die Konzentration von Bor, Phosphor, Antimon $c_B$, $c_P$, $c_{Sb}$ (= erste epitaktische Schicht) und als Abszisse die Eindringtiefe X in μm aufgetragen.

2. Ausführungsbeispiel:

Der Unterschied zum ersten Ausführungsbeispiel besteht darin, daß bei dieser Prozeßvariante mit der Erzeugung einer p$^+$ (6) und n$^+$-vergrabenen Schicht (28) begonnen wird. Die im ersten Ausführungsbeispiel vorgenommenen Wannenimplantationen (13 und 14) werden durch die Ausdiffusion der vergrabenen Schichten (6, 28) ersetzt und somit wird ein Photolithographieschritt eingespart. Im Vergleich zum Ausführungsbeispiel 1 ermöglicht diese Variante eine Erhöhung der Wannendurchbruchsspannung und eine Verminderung der Wannen-Substrat-Kapazität.

Figur 10: Der Prozeßverlauf ergibt sich für den Anfang des Prozesses analog Figur 1. Die Aufoxidation der Oberfläche zur Maskierung des vergrabenen p-Schichtbereiches 6 (siehe Figur 2) wird hier so geführt, daß die Oxidschicht 7 mit einem langen Vogelschnabel-ähnlichen Auslauf 27 zur Trennung beider vergrabener Schichten (6 und 28) entsteht.

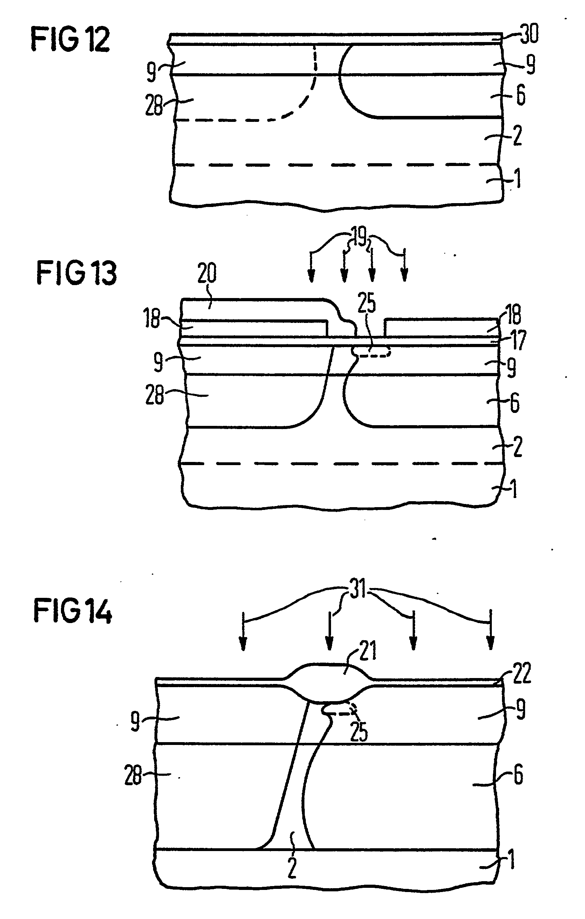

Figur 11: Zur Erzeugung der vergrabenen n-dotierten Schicht 28 wird nun nach der Nitridätzung (4) eine Phosphor-Ionen-Implantation 29 mit einer Dosis und Energie von $1 \times 10^{14}$ cm$^{-2}$ und 40 keV durchgeführt.

Figur 12: Nach der Abätzung der als Maskierung dienenden Oxidschicht (3, 7, 27) wird die zweite n$^-$-dotierte Epitaxieschicht 9 (1 μm dick, 20 Ohm cm) aufgebracht und darüber ganzflächig eine isolierende SiO$_2$-Schicht 30 in einer Schichtdicke von 50 nm. Nun erfolgt die gemeinsame Ausdiffusion der beiden "buried layers" 6 und 28 bei 1000°C in 200 bis 250 Minuten.

Figur 13: Jetzt wird analog Figur 8 eine aus 50 nm SiO$_2$ und 140 nm Siliziumnitrid bestehende Doppelschicht 17, 18 zur Vorbereitung auf den LOCOS-Prozeß erzeugt und strukturiert. Die Figur zeigt die Anordnung während der Ionenimplantation 19 der Gebiete der n-Kanal-Feldoxid-Transistoren mit Bor-Ionen ($1 \times 10^{13}$ cm$^{-2}$ und 60 bis 90 keV). Dabei ist, wie bei Figur 8 beschrieben, der n-Wannenbereich (15) mit einer Photolackmaske 20 abgedeckt. Es entsteht der mit 25 bezeichnete p-dotierte Bereich.

Figur 14: Nach der Entfernung der Photolackmaske 20 wird analog Figur 9 das Feldoxid 21 erzeugt. Die Entfernung der Nitridmaske und die Aufoxidation der Oxidschicht 17 erfolgt analog, ebenso alle folgenden Prozesse, wie bereits bei Figur 9 beschrieben mit Ausnahme der Kanalimplantation 31. Diese wird in zwei aufeinanderfolgenden Schritten durchgeführt (im einzelnen in der Figur nicht dargestellt), wobei zunächst eine tiefe Bor-Ionenimplantation mit einer Dosis und Energie von 5 bis $10 \times 10^{11}$ cm$^{-2}$ und 60 - 120 keV und dann eine flache Bor-Ionenimplantation mit einer Dosis und Energie von 5 bis $7 \times 10^{11}$ cm$^{-2}$ und 25 keV durchgeführt wird. Die Dotierung der p-Kanal-Transistoren wird entsprechend vorgenommen.

Das im aktiven Bereich der n-Kanal-Transistoren erreichte Dotierungsprofil ist qualitativ in Figur 16, das für den p-Kanal-Transistor erreichte Dotierungsprofil qualitativ in Figur 17 dargestellt (es gelten die gleichen Bezeichnungen wie in Figur 15).

**Patentansprüche**

1. Verfahren zum Herstellen von hochintegrierten, komplementären MOS-Feldeffekttransistorschaltungen (CMOS-Schaltungen), bei dem für die Aufnahme der n- bzw. p-Kanal-Transistoren der Schaltung im Halbleitersubstrat p- bzw. n-dotierte Wannen erzeugt werden, in welche zur Einstellung der verschiedenen Transistoreinsatzspannungen die entsprechenden Dotierstoffatome durch Ionenimplantationen eingebracht werden, bei dem als Halbleiterstubstrat n+- bzw. p+-dotiertes Silizium mit einer darauf befindlichen n⁻- bzw. p⁻-dotierten ersten Epitaxieschicht verwendet wird und bei dem die Herstellung der Source/Drain- und Gatebereiche sowie die Erzeugung des Zwischen- und Isolationsoxids und der Leiterbahnebene nach bekannten Verfarensschritten der MOS-Technologie vorgenommen wird, dadurch gekennzeichnet, daß

a) auf die n⁻- bzw. p⁻-dotierte erste Epitaxieschicht (2) eine zweite epitaxiale Schicht (9), die von demselben Leitfähigkeitstyp wie die erste Epitaxieschicht (2) ist, aufgebracht wird,

b) in den oberen Bereich der tieferen, ersten Epitaxieschicht (2) vor dem Aufbringen der zweiten, darüberliegenden epitaxialen Schicht (9) in den späteren Wannenbereichen vergrabene Zonen (6, 28) (sogenannte buried layers) mit vergleichsweise hoher Dosis implantiert werden und

c) die Wannen durch Ausdiffusion dieser hochdotierten vergrabenen Zonen (6, 28) in die zweite (obere) epitaxiale Schicht (9) erzeugt werden.

2. Verfahren zum Herstellen einer CMOS-Schaltung nach Anspruch 1, dadurch gekennzeichnet, daß in die zweite epitaxiale Schicht (9) Ionen (13, 14) implantiert werden und daß die Wannen (12, 15) zusätzlich durch Diffusion der in die zweite epitaxiale Schicht (9) implantierten Ionen (13, 14) erzeugt werden.

3. Verfahren zum Herstellen einer CMOS-Schaltung nach Anspruch 2, bei dem von n+-dotiertem Siliziumgrundmaterial (1) und einer ersten n⁻-dotierten epitaxialen Siliziumschicht (2) ausgegangen wird, gekennzeichnet durch den Ablauf folgender Verfahrensschritte:

a) Erzeugung einer isolierenden, aus SiO₂ und Siliziumnitrid bestehenden Doppelschicht (3, 4) auf dem mit der n⁻-dotierten epitaxialen Schicht (2) versehenen n+-dotierten Siliziumsubstrat (1) und Strukturierung der Siliziumnitridschicht (4) mit der Photolackmaske (32), durch die der spätere n-Wannenbereich abgedeckt wird,

b) Herstellung einer hochdotierten vergrabenen Zone (6) (buried layer) durch Bor-Ionenimplantation (5) im späteren p-Wannenbereich unter Verwendung der Photolackmaske (32) und der Siliziumnitridschicht (4) als Maskierung,

c) Aufoxidation der Oxidschicht (7) im p-Wannenbereich nach Entfernung der Photolackmaske (32),

d) Entfernung der Siliziumnitridschicht (4) im n-Wannenbereich und Entfernung des darunterliegenden Oxids (3, 7),

e) ganzflächige Abscheidung einer zweiten n-dotierten epitaxialen Schicht (9),

f) Erzeugung einer isolierenden, aus SiO₂ und Siliziumnitrid bestehenden Doppelschicht (10, 11) und Strukturierung der Siliziumnitridschicht (11) mit der Photolackmaske (33) zur Abdeckung der n-Wannenbereiche,

g) Herstellung der p-Wanne (12) durch eine Bor-Ionenimplantation (13) in der n-dotierten, zweiten epitaxialen Schicht (9) unter Verwendung der Photolackmaske (33) und der Siliziumnitridschicht (11),

h) Durchführung einer Temperung und eines Oxidationsprozesses nach Entfernung der Photolackmaske (33) zur Maskierung des p-Wannenbereiches,

i) Herstellung der n-Wanne (15) durch eine Phosphor-Ionenimplantation (14) und anschließende Eindiffusion der Bor- und Phosphor-Ionen zur Bildung der jeweiligen Wannen (12, 15),

j) Entfernung der gesamten Oberflächenoxidschicht (10, 16),

k) Durchführung der Implantation (19) für die n-Kanal-Feldoxid-Transistoren im Bereich der p-Wanne (12) nach Maskierung der n-Wannen-Bereiche (15) mittels einer Photolackschicht (20) und der gesamten aktiven Transistorbereiche der n-Kanal- bzw. der p-Kanal-Transistoren mit einer Siliziumnitridschicht (18),

l) Herstellung der Feldoxidbereiche (21) nach Entfernung der Photolackmaske (20) mittels lokaler Oxidation unter Verwendung der Siliziumnitridschicht (18) als Maskierung,

m) thermische Oxidation der gesamten Oberfläche nach Ablösung der Siliziumnitridmaskierung (18),

n) Abätzen der Oxidschicht und Erzeugen des Gateoxids (22) in definierter Dicke,

o) ganzflächige Bor-Ionenimplantation (23) zur p- und n-Kanaldotierung zur Einstellung der Einsatzspannung beider Transistortypen,

p) Herstellung der Gate-Elektroden, der Source/Drain-Zonen, der Isolationszwischenschicht, der Kontaktlochbereiche und der Metallisierungsebene in bekannter Weise.

4. Verfahren zum Herstellen einer CMOS-Schaltung nach Anspruch 1, bei dem von n+-dotiertem Siliziumgrundmaterial (1) und einer ersten n⁻-dotierten epitaxialen Siliziumschicht (2) ausgegangen wird, gekennzeichnet durch den Ablauf folgender Verfahrensschritte:

a) Erzeugung einer isolierenden, aus SiO₂ und Siliziumnitrid bestehenden Doppelschicht (3, 4) auf dem mit der n⁻-dotierten epitaxialen Schicht (2) versehenen n+-dotierten Siliziumsubstrat (1) und Strukturierung der Siliziumnitridschicht (4) mit der Photolackmaske (32), durch die der spätere n-Wannenbereich abgedeckt wird,

b) Herstellung einer hochdotierten, vergrabenen Zone (6) (buried layer) durch Bor-Ionenimplantation (5) im späteren p-Wannenbereich unter Verwendung der Photolackmaske (32) und der Siliziumnitridschicht (4) als Maskierung,

c) Durchführung eines Oxidationsprozesses zur Maskierung der hochdotierten vergrabenen Zone (6) im späteren p-Wannenbereich mit einer Oberflächenoxidschicht (7) mit vogelschnabelähnlichem Auslauf (27) (birds beak) nach Entfernung der Photolackmaske,

d) Herstellung einer hochdotierten, vergrabenen Zone (28) (buried layer) durch Phosphor- oder

Arsen-Ionenimplantation (29) im späteren n-Wannenbereich nach Entfernung der Nitridschicht,

e) Abätzung des Maskieroxids (7, 27) und ganzflächige Abscheidung der zweiten epitaxialen Schicht (9),

f) ganzflächige Herstellung einer isolierenden Oxidschicht (30) und gemeinsame Ausdiffusion der hochdotierten vergrabenen Zonen (6, 28) in die jeweiligen Wannen,

g) Durchführung der Implantation (19) für die n-Kanal-Feldoxid-Transistoren im Bereich der p-Wanne nach Maskierung der n-Wannen-Bereiche mittels einer Photolackschicht (20) und der gesamten aktiven Transistorbereiche der n-Kanal- bzw. p-Kanal-Transistoren mit einer Siliziumnitridschicht (18),

h) Herstellung der Feldoxidbereiche (21) nach Entfernung der Photolackmaske (20) mittels lokaler Oxidation unter Verwendung der Siliziumnitridschicht (18) als Maskierung,

i) thermische Oxidation der gesamten Oberfläche nach Ablösung der Siliziumnitridmaskierung (18), j) Abätzen der Oxidschicht und Erzeugen des Gateoxids (22) in definierter Dicke,

k) Durchführung der Kanaldotierung (31) mit Bor-Ionen in zwei Schritten, wobei zunächst eine tiefe und dann eine flache Implantation durchgeführt wird,

l) Herstellung der Gate-Elektroden, der Source/Drain-Zonen, der Isolationszwischenschichten, der Kontaktlochbereiche und der Metallisierungsebene in bekannter Weise.

5. Verfahren nach einem der Ansprüche 1 bis 4, dadurch gekennzeichnet, daß die erste Epitaxieschicht (2) auf eine Schichtdicke im Bereich von 3 µm und einen spezifischen Widerstand von 0,5 Ohm x cm und die zweite Epitaxieschicht (9) auf eine Schichtdicke im Bereich von 1 mm und einen spezifischen Widerstand von 20 Ohm x cm eingestellt wird und daß ein Siliziumsubstrat (1) mit einem spezifischen Widerstand von 0,020 Ohm x cm verwendet wird.

6. Verfahren nach einem der Ansprüche 1 bis 5, dadurch gekennzeichnet, daß die Erzeugung der hochdotierten vergrabenen Zone (6) mit Bor-Ionen mit einer Dosis und Energie von $1 \times 10^{14}$ Bor $cm^{-2}$ und 25 keV durchgeführt wird.

7. Verfahren nach einem der Ansprüche 1 bis 6, dadurch gekennzeichnet, daß die Aufoxidation der Oxidschicht (7) nach Verfahrensschritt c) bis zu einer Schichtdicke von 200 nm durchgeführt wird.

8. Verfahren nach einem der Ansprüche 3 und 5 bis 7, dadurch gekennzeichnet, daß die Erzeugung der p-Wanne (12) mit einer Dosis und Energie von $2 \times 10^{12}$ Bor$^+$ $cm^{-2}$ und 160 keV durchgeführt wird.

9. Verfahren nach einem der Ansprüche 3 und 5 bis 8, dadurch gekennzeichnet, daß die Erzeugung der n-Wanne (15) mit einer Dosis und Energie von $1 \times 10^{12}$ Phosphor$^+$ $cm^{-2}$ und 160 keV durchgeführt wird.

10. Verfahren nach einem der Ansprüche 4 bis 7, dadurch gekennzeichnet, daß die Erzeugung der hochdotierten vergrabenen Zone (28) mit Arsen- oder Phosphor-Ionen mit einer Dosis und Energie von $1 \times 10^{14}$ $cm^{-2}$ und 40 keV durchgeführt wird.

11. Verfahren nach einem der Ansprüche 3 und 5 bis 9, dadurch gekennzeichnet, daß die Temperaturbehandlung zur Eindiffusion der Wannenbereiche (12, 15) bei 1000°C in zwei bis drei Stunden durchgeführt wird.

12. Verfahren nach einem der Ansprüche 4 bis 7 und 10, dadurch gekennzeichnet, daß die gemeinsame Ausdiffusion der hochdotierten vergrabenen Zonen (6, 28) in die jeweiligen Wannen bei 1000°C in drei bis fünf Stunden durchgeführt wird.

13. Verfahren nach einem der Ansprüche 1 bis 12, dadurch gekennzeichnet, daß die Schichtdicke der aus SiO$_2$ und Siliziumnitrid bestehenden Doppelschicht (3, 4, 10, 11, 17, 18) auf 50 nm Oxid und 140 nm Nitrid eingestellt wird.

14. Verfahren nach einem der Ansprüche 1 bis 13, dadurch gekennzeichnet, daß die Feldimplantation (19) mit einer Dosis und Energie von $1 \times 10^{13}$ Bor$^+$ $cm^{-2}$ und 25 keV durchgeführt wird.

15. Verfahren nach einem der Ansprüche 3, 5 bis 11, 13 und 14, dadurch gekennzeichnet, daß die Kanalimplantation (23) mit einer Dosis und Energie von $5 \times 10^{11}$ Bor$^+$ $cm^{-2}$ und 25 keV durchgeführt wird.

16. Verfahren nach einem der Ansprüche 4 bis 7 und 12 bis 14, dadurch gekennzeichnet, daß die Kanalimplantation (31) in der ersten Stufe mit einer Dosis und Energie von 5 bis $10 \times 10^{11}$ Bor$^+$ $cm^{-2}$ und 60 bis 120 keV und dann nach Entfernung der Maskierungsschichten in der zweiten Stufe mit 5 bis $7 \times 10^{11}$ Bor$^+$ $cm^{-2}$ und 25 keV durchgeführt wird.

**Claims**

1. Method of producing highly integrated complementary MOS field-effect transistor circuits (CMOS circuits), in which p-doped and n-doped wells are generated in the semiconductor substrate for receiving the n-channel and p-channel transistors, respectively, of the circuit, into which wells the corresponding dopant atoms for setting the various transistor threshold voltages are introduced by ion implantations, in which n$^+$-doped and p$^+$-doped silicon with an n$^-$-doped and p$^-$-doped first epitaxial layer thereon is used as semiconductor substrate and in which the production of the source/drain and gate regions as well as the generation of the intermediate and insulating oxide and of the conductor path level is performed by known method steps of MOS technology, characterized in that

a) a second epitaxial layer (9), which is of the same conductivity type as the first epitaxial layer (2), is applied to the n$^-$-doped or p$^-$-doped first epitaxial layer (2),

b) buried zones (6, 28) (so-called buried layers) of comparatively high dosage are implanted in the upper region of the deeper, first epitaxial layer (2), before applying the second epitaxial layer (9) thereon, in the subsequent well regions, and

c) the wells are generated by diffusing out these highly doped buried zones (6, 28) into the second (upper) epitaxial layer (9).

2. Method of producing a CMOS circuit according to Claim 1, characterized in that ions (13, 14) are implanted in the second epitaxial layer (9) and in that the wells (12, 15) are additionally generated by diffusion of the ions (13, 14) implanted in the second epitaxial layer (9).

3. Method of producing a CMOS circuit according to Claim 2, in which n+-doped silicon substrate (1) and a first n⁻-doped epitaxial silicon layer (2) are used as a basis, characterized by the sequence of the following method steps:

a) generating an insulating double layer (3, 4), consisting of SiO₂ and silicon nitride, on the n+-doped silicon substrate (1), provided with the n⁻-doped epitaxial layer (2), and structuring the silicon nitride layer (4) with the photoresist mask (32), by which the subsequent n-well region is covered,

b) producing a highly doped buried zone (6) (buried layer) by boron ion implantation (5) in the subsequent p-well region, using the photoresist mask (32) and the silicon nitride layer (4) as masking,

c) oxidizing the oxide layer (7) in the p-well region after removal of the photoresist mask (32),

d) removing the silicon nitride layer (4) in the n-well region and removing the underlying oxide (3, 7),

e) surface-wide depositing of a second n-doped epitaxial layer (9),

f) generating an insulating double layer (10, 11), consisting of SiO₂ and silicon nitride, and structuring the silicon nitride layer (11) with the photoresist mask (33) for covering the n-well regions,

g) producing the p-well (12) by a boron ion implantation (13) in the n-doped, second epitaxial layer (9), using the photoresist mask (33) and the silicon nitride layer (11),

h) carrying out a heat treatment and an oxidation process after removal of the photoresist mask (33) for masking the p-well region,

i) producing the n-well (15) by a phosphorus ion implantation (14) and subsequent diffusing in of the boron and phosphorus ions for forming the respective wells (12, 15),

j) removing the entire surface oxide layer (10, 16),

k) carrying out the implantation (19) for the n-channel field-oxide transistors in the region of the p-well (12) after masking of the n-well regions (15) by means of a photoresist layer (20) and of the entire active transistor regions of the n-channel transistors and of the p-channel transistors with a silicon nitride layer (18),

l) producing the field-oxide regions (21) after removing the photoresist mask (20) by means of local oxidation, using the silicon nitride layer (18) as masking,

m) thermally oxidizing the entire surface after stripping off the silicon nitride masking (18), n) etching off the oxide layer and generating the gate oxide (22) in a defined thickness,

o) surface-wide boron ion implantation (23) for p-channel and-n-channel doping to set the threshold voltage of both transistor types,

p) producing the gate electrodes, the source/drain zones, the insulation intermediate layer, the contact hole regions and the metallization level in a known way.

4. Method of producing a CMOS circuit according to Claim 1, in which n+-doped silicon substrate (1) and a first n⁻-doped epitaxial silicon layer (2) are used as a basis, characterized in the sequence of the following method steps:

a) generating an insulating double layer (3, 4), consisting of SiO₂ and silicon nitride, on the n+-doped silicon substrate (1), provided with the n⁻-doped epitaxial layer (2), and structuring the silicon nitride layer (4) with the photoresist mask (32), by which the subsequent n-well region is covered,

b) producing a highly doped buried zone (6) (buried layer) by boron ion implantation (5) in the subsequent p-well region, using the photoresist mask (32) and the silicon nitride layer (4) as masking,

c) carrying out an oxidation process for masking the highly doped buried zone (6) in the subsequent p-well region with a surface oxide layer (7) with bird's beak-like run-out (27)      (bird's beak) after removing the photoresist mask,

d) producing a highly doped, buried zone (28) (buried layer) by phosphorus ion or arsenic ion implantation (29) in the subsequent n-well region after removing the nitride layer,

e) etching away the masking oxide (7, 27) and surface-wide depositing of the second epitaxial layer (9),

f) producing a surface-wide insulating oxide layer (30) and commonly diffusing out the highly doped buried zones (6, 28) into the respective wells,

g) carrying out the implantation (19) for the n-channel field-oxide transistors in the region of the p-well after masking of the n-well regions by means of a photoresist layer (20) and of the entire active transistor regions of the n-channel transistors and p-channel transistors with a silicon nitride layer (18),

h) producing the field-oxide regions (21) after removing the photoresist mask (20) by means of local oxidation, using the silicon nitride layer (18) as masking,

i) thermally oxidizing the entire surface after stripping off the silicon nitride masking (18),

j) etching away the oxide layer and generating the gate oxide (22) in a defined thickness,

k) carrying out channel doping (31) with boron ions in two steps, firstly a deep implantation and then a flat implantation being carried out,

l) producing the gate electrodes, the source/drain zones, the insulating intermediate layers, the contact hole regions and the metallization level in a known way.

5. Method according to one of Claims 1 to 4, characterized in that the first epitaxial layer (2) is set to a layer thickness in the range of 3 μm and a specific resistance of 0.5 ohm × cm and the second epitaxial layer (9) is set to a layer thickness in the range of 1 μm and a specific resistance of 20 ohms × cm and in that a silicon substrate (1) having a specific resistance of 0.020 ohm × cm is used.

6. Method according to one of Claims 1 to 5, characterized in that the generating of the highly doped buried zone (6) is carried out with boron ions at a

dosage of $1 \times 10^{14}$ boron $cm^{-2}$ and an energy level of 25 keV.

7. Method according to one of Claims 1 to 6, characterized in that the oxidizing of the oxide layer (7) according to method step c) is carried out to a layer thickness of 200 nm.

8. Method according to one of Claims 3 and 5 to 7, characterized in that the generating of the p-well (12) is carried out a dosage of $2 \times 10^{12}$ boron$^+$ $cm^{-2}$ and an energy level of 160 keV.

9. Method according to one of Claims 3 and 5 to 8, characterized in that the generating of the n-well (15) is carried out at a dosage of $1 \times 10^{12}$ phosphorus$^+$ $cm^{-2}$ and an energy level of 160 keV.

10. Method according to one of Claims 4 to 7, characterized in that the generating of the highly doped buried zone (28) is carried out with arsenic ions or phosphorus ions at a dosage of $1 \times 10^{14}$ $cm^{-2}$ and an energy level of 40 keV.

11. Method according to one of Claims 3 and 5 to 9, characterized in that the one of Claims 3 and 5 to 9, characterized in that the temperature treatment for diffusing in of the well regions (12, 15) is carried out at 1,000°C in two to three hours.

12. Method according to one of Claims 4 to 7 and 10, characterized in that the common diffusing out of the highly doped buried zones (6, 28) into the respective wells is carried out at 1,000°C in three to five hours.

13. Method according to one of Claims 1 to 12, characterized in that the layer thickness of the double layer (3, 4, 10, 11, 17, 18), consisting of $SiO_2$ and silicon nitride, is set to 50 nm of oxide and 140 nm of nitride.

14. Method according to one of Claims 1 to 13, characterized in that the field implantation (19) is carried out at a dosage of $1 \times 10^{13}$ boron$^+$ $cm^{-2}$ and an energy level of 25 keV.

15. Method according to one of Claims 3, 5 to 11, 13 and 14, characterized in that the channel implantation (23) is carried out at a dosage of $5 \times 10^{11}$ boron$^+$ $cm^{-2}$ and an energy level of 25 keV.

16. Method according to one of Claims 4 to 7 and 12 to 14, characterized in that the channel implantation (31) is carried out in the first stage at a dosage of 5 to $10 \times 10^{11}$ boron$^+$ $cm^{-2}$ and an energy level of 60 to 120 keV and then, after removing the masking layers, in the second stage at 5 to $7 \times 10^{11}$ boron$^+$ $cm^{-2}$ and 25 keV.

**Revendications**

1. Procédé pour fabriquer des circuits à transistors à effet de champ MOS complémentaires (circuits CMOS), à haute densité d'intégration, selon lequel, pour l'insertion des transistors à canal n ou à canal p du circuit dans le substrat semiconducteur, on forme des cuvettes dopées de type p ou de type n, dans lesquelles, pour régler les différentes tensions de déclenchement des transistors, on insère les atomes correspondants de substances dopantes au moyen d'implantations ioniques, et selon lequel on utilise comme substrat semiconducteur du silicium dopé de type n$^+$ ou p$^+$, sur lequel est disposé une première couche épitaxiale dopée de type n$^-$ ou p$^-$, et selon lequel on fabrique les régions de source/drain et de grille et on forme l'oxyde intercalaire, l'oxyde isolant et le plan des voies conductrices selon des étapes opératoires connues de la technologie MOS, caractérisé par le fait que

a) sur la première couche épitaxiale (2) dopée du type n$^-$ ou p$^-$, on dépose une seconde couche épitaxiale (9), qui possède le même type de conductivité que la première couche épitaxiale (2),

b) dans la zone supérieure de la première couche épitaxiale plus profonde (2) on forme par implantation, avant le dépôt de la seconde couche épitaxiale surjacente (9), des zones ensevelies (6, 28) (ce qu'on appelle des buried layers) dans les régions des cuvettes formées ultérieurement, en utilisant une dose comparativement élevée, et

c) on forme les cuvettes en faisant diffuser ces zones ensevelies fortement dopées (6, 28) dans la seconde couche épitaxiale (supérieure) (9).

2. Procédé pour fabriquer un circuit CMOS suivant la revendication 1, caractérisé par le fait qu'on implante des ions (13, 14) dans la seconde couche épitaxiale (9) et qu'on forme en supplément les cuvettes (12, 15) par diffusion des ions (13, 14) implantés dans la seconde couche épitaxiale (9).

3. Procédé pour fabriquer un circuit CMOS suivant la revendication 2, selon lequel on part d'un matériau de base (1) formé de silicium dopé du type n$^+$ et d'une première couche épitaxiale de silicium (2) dopé du type n$^-$, caractérisé par l'exécution des étapes opératoires suivantes:

a) production d'une couche isolante double (3, 4) constituée par du $SiO_2$ et du nitrure de silicium, sur le substrat en silicium (1) dopé du type n$^+$ et pourvu de la couche épitaxiale (2) dopée du type n$^-$, et structuration de la couche de nitrure de silicium (4) à l'aide du masque de laque photosensible (32), qui recouvre la région de la cuvette de type n formée ultérieurement,

b) fabrication d'une zone ensevelie fortement dopée (6) (buried layer) par implantation d'ions de bore (5) dans la région de la cuvette de type p formée ultérieurement, moyennant l'utilisation, come masquage, du masque de laque photosensible (32) de la couche de nitrure de silicium (4),

c) formation de la couche d'oxyde (7) par oxydation superficielle dans la région de la cuvette de type p après élimination du masque de laque photosensible (32),

d) élimination de la couche de nitrure de silicium (4) dans la région de la cuvette de type n et élimination de l'oxyde (3, 7) situé au-dessous de cette région,

e) dépôt, sur l'ensemble de la surface, d'une seconde couche épitaxiale (9) dopée du type n,

f) production d'une couche double isolante (10, 11) constituée par du $SiO_2$ et du nitrure de silicium et structuration de la couche de nitrure de silicium (11) à l'aide du masque de laque photosensible (33) servant à recouvrir les régions de la cuvette de type n,

g) fabrication des cuvettes de type p (12) au moyen d'une implantation d'ions de bore (13) dans une seconde couche épitaxiale (9) dopée du type n, moyennant l'utilisation du masque de laque photosensible (33) et de la couche de nitrure de silicium (11),

h) exécution d'un recuit et d'un processus d'oxydation après élimination du masque de laque photosensible (33) servant à masquer la région de la cuvette dy type p,

i) fabrication de la cuvette de type n (15) au moyen d'une implantation d'ions de phosphore (14) et diffusion ultérieure des ions de bore et de phosphore pour la formation des cuvettes respectives (12, 15),

j) élimination de l'ensemble de la couche d'oxyde superficiel (10, 16),

k) exécution de l'implantation (19) pour les transistors à oxyde de champ à canal n dans la région de la cuvette de type p (12) après masquage des régions (15) des cuvettes de type n à l'aide d'une couche de laque photosensible (20) et masquage de l'ensemble des régions actives des transistors à canal n et à canal p par une couche de nitrure de silicium (18),

l) fabrication des régions d'oxyde de champ (21) après élimination du masque de laque photosensible (20) au moyen d'une oxydation locale moyennant l'utilisation, comme masquage, de la couche de nitrure de silicium (18),

m) oxydation thermique de l'ensemble de la surface après élimination par dissolution du masque (18) formé par le nitrure de silicium,

n) élimination par corrosion de la couche d'oxyde et production de l'oxyde de grille (22) sur une épaisseur définie,

o) implantation d'ions de bore (23) sur toute la surface pour réaliser le dopage du canal de type p et du canal de type n de manière à régler la tension de déclenchement des deux transistors,

p) fabrication des électrodes de grille, des zones de source/drain, de la couche intercalaire isolante, des zones des trous de contact et du plan de métallisation, d'une manière connue.

4. Procédé pour fabriquer un circuit CMOS suivant la revendication 1, selon lequel on part d'un matériau de base (1) formé de silicium dopé du type n+ et d'une première couche épitaxiale de silicium (2) dopée du type n, caractérisé par l'exécution des étapes opératoires suivantes:

a) production d'une couche isolante double (3, 4) constituée par du SiO₂ et du nitrure de silicium, sur le substrat en silicium (1) dopé du type n+ et pourvu de la couche épitaxiale (2) dopée du type n⁻, et structuration de la couche de nitrure de silicium (4) à l'aide du masque de laque photosensible (32), qui recouvre la région de la cuvette du type n formée ultérieurement,

b) fabrication d'une zone ensevelie fortement dopée (6) (buried layer) par implantation d'ions de bore (5) dans la région de la cuvette de type p formée ultérieurement, moyennant l'utilisation, comme masquage, du masque de laque photosensible (32) de la couche de nitrure de silicium (4),

c) exécution d'un processus d'oxydation servant à masquer la zone ensevelie fortement dopée (6) dans la région de la cuvette de type p, formée ultérieurement, au moyen d'une couche d'oxyde superficiel (7) comportant un élargissement en forme de bec d'oiseau (27) (birds beak) après élimination du masque de laque photosensible,

d) fabrication d'une zone ensevelie fortement dopée (28) (buried layer) au moyen d'une implantation d'ions de phosphore ou d'arsenic (29) dans la région de la cuvette de type n, formée ultérieurement, après élimination de la couche de nitrure,

e) élimination par corrosion de l'oxyde de masquage (7, 27) et dépôt, sur toute la surface, de la seconde couche épitaxiale (9),

f) fabrication, sur toute la surface, d'une couche d'oxyde isolante (30) et diffusion commune des zones ensevelies fortement dopées (6, 28) dans les cuvettes respectives,

g) exécution de l'implantation (19) pour les transistors à oxyde de champ à canal n dans la région de la cuvette de type p (12) après masquage des régions (15) des cuvettes de type n à l'aide d'une couche de laque photosensible (20) et masquage de l'ensemble de régions actives des transistors à canal n et à canal p par une couche de nitrure de silicium (18),

h) fabrication des régions d'oxyde de champ (21) après élimination du masque de laque photosensible (20) au moyen d'une oxydation locale moyennant l'utilisation, comme masquage, de la couche de nitrure de silicium (18),

i) oxydation thermique de l'ensemble de la surface après élimination par dissolution du masque (18) formé par le nitrure de silicium,

j) élimination par corrosion de la couche d'oxyde et production de l'oxyde de grille (22) sur une épaisseur définie,

k) implantation d'ions de bore (23) sur toute la surface pour réaliser le dopage du canal de type p et du canal de type n de manière à régler la tension de déclenchement des deux transistors,

l) fabrication des électrodes de grille, des zones de source/drain, de la couche intercalaire isolante, des zones des trous de contact et du plan de métallisation, d'une manière connue.

5. Procédé suivant l'une des revendications 1 à 4, caractérisé par le fait qu'on règle la première couche épitaxiale (2) de manière qu'elle possède une épaisseur de l'ordre de 3 μm et une résistance spécifique de 0,5 ohm x cm et qu'on règle la seconde couche épitaxiale (9) de manière qu'elle possède une épaisseur de l'ordre de 1 μm et une résistance spécifique de 20 ohms x cm et qu'on utilise un substrat en silicium (1) possédant une résistance spécifique de 0,020 ohm x cm.

6. Procédé suivant l'une des revendications 1 à 5, caractérisé par le fait qu'on forme la zone ensevelie fortement dopée (6) à l'aide d'ions de bore en utilisant une dose et une énergie égales respectivement à 1 x 10¹⁴ bore cm⁻² et 25 keV.

7. Procédé suivant l'une des revendications 1 à 6, caractérisé par le fait qu'on exécute l'oxydation superficielle de la couche d'oxyde (7) selon l'étape opératoire (c) pour obtenir une épaisseur de couche atteignant jusqu'à 200 nm.

8. Procédé suivant l'une des revendications 3 et 5 à 7, caractérisé par le fait qu'on forme la cuvette de type p (12) en utilisant une dose et une énergie égale respectivement à $2 \times 10^{12}$ bore$^+$ cm$^{-2}$ et 160 keV.

9. Procédé suivant l'une des revendications 3 et 5 à 8, caractérisé par le fait qu'on forme la cuvette de type n (15) en utilisant une dose et une énergie égales respectivement à $1 \times 10^{12}$ phosphore$^+$ cm$^{-2}$ et 160 keV.

10. Procédé suivant l'une des revendications 4 à 7, caractérisé par le fait qu'on forme la zone ensevelie fortement dopée (28) à l'aide d'ions d'arsenic ou de phosphore et en utilisant une dose et une énergie égales respectivement à $1 \times 10^{14}$ cm$^{-2}$ et 40 keV.

11. Procédé suivant l'une des revendications 3 et 5 à 9, caractérisé par le fait qu'on réalise le traitement thermique prévu pour la diffusion des régions des cuvettes des régions des cuvettes 12, 15) à 1000°C en un laps de temps compris entre 2 et 3 heures.

12. Procédé suivant l'une des revendications 4 à 7 et 10, caractérisé par le fait qu'on exécute la diffusion commune des zones ensevelies fortement dopées (6, 28) dans les cuvettes respectives à 1000°C en un laps de temps compris entre 3 et 5 heures.

13. Procédé suivant l'une des revendications 1 à 12, caractérisé par le fait qu'on règle l'épaisseur de la couche double (3, 4, 10, 11, 17, 18) constituée par du SiO$_2$ et du nitrure de silicium de manière à avoir une épaisseur d'oxyde de 50 nm et une épaisseur de nitrure de 140 nm.

14. Procédé suivant l'une des revendications 1 à 13, caractérisé par le fait qu'on réalise l'implantation de champ (19) en utilisant une dose et une énergie égales respectivement à $1 \times 10^{13}$ bore$^+$ cm$^{-2}$ et 25 keV.

15. Procédé suivant l'une des revendications 3,5 à 11, 13 et 14, caractérisé par le fait qu'on réalise l'implantation (23) des canaux en utilisant une dose et une énergie égales respectivement à $5 \times 10^{11}$ bore$^+$ cm$^{-2}$ et 25 keV.

16. Procédé suivant l'une des revendications 4 à 7 et 12 à 14, caractérisé par le fait qu'on exécute l'implantation (31) des canaux lors de la première étape, en utilisant une dose et une énergie comprises respectivement entre 5 et $10 \times 10^{11}$ bore$^+$ cm$^{-2}$ et entre 60 et 120 keV, puis, après élimination des couches de masquage, lors de la seconde étape, en utilisant une dose comprise entre 5 et $7 \times 10^{11}$ bore$^+$ cm$^{-2}$ et une énergie égale à 25 keV.

**FIG 1**

**FIG 2**

**FIG 3**

**FIG 4**

**FIG 5**

FIG 6

FIG 7

FIG 8

FIG 9

FIG 10

FIG 11

**FIG 12**

**FIG 13**

**FIG 14**